# EUROPEAN PATENT APPLICATION

(11) **EP 4 574 786 A1**
(43) Date of publication of application: **25.06.2025**
(21) Application number: 24212089.7
(22) Date of filing: 11.11.2024
(51) Int. Cl.: C03C 17/00, B05D 1/00, H01L 23/00

(54) **APPARATUS AND SYSTEM FOR COATING OF GLASS SUBSTRATE HAVING A PLURALITY OF THROUGH-HOLES**

(30) Priority: 20.12.2023 US 202318389860
(71) Applicant: INTEL Corporation, Santa Clara, CA 95054 (US)
(72) Inventor: STACEY, Joshua, Chandler, AZ, 85226 (US); BRYKS, Whitney, Tempe, AZ, 85284 (US); WANDERA, Daniel, Beaverton, OR 97005 (US); CANDADAI, Aaditya Anand, Chandler, AZ, 85226 (US); MOHAMMADIGHALENI, Mahdi, Phoenix, AZ, 85048 (US)
(74) Representative: Viering, Jentschura & Partner mbB Patent- und Rechtsanwälte

(57) **Abstract**

An apparatus for coating a glass substrate having a plurality of through-holes, the apparatus including a support frame including one or more abutment portions configured to support the glass substrate in a levelled orientation; a dispenser head operable to deposit a liquid coating on the glass substrate; and a coating unit configured to apply a force on the liquid coating so as to urge the liquid coating to permeate the plurality of through-holes in the glass substrate.

## Description

### Technical Field

Various aspects relate generally to an apparatus for coating of glass substrate having a plurality of through-holes, or a system for coating of glass substrate having a plurality of through-holes. In particular, the apparatus and system of the various aspects may be related to coating the plurality of through-holes of the glass substrate, using liquid coating, for producing through-glass-vias (TGV) substrate.

### Background

Stress in through-glass-vias (TGV) substrate can be generated due to coefficients of thermal expansion (CTE) mismatch between glass and the plated metal (e.g. copper, Cu) vias. This is accentuated by high-temperature process (e.g. greater than 250 °C) since cooling metal (e.g. Cu) shrinks more than glass and leaves residual tensile stress in the glass which in turn compromises its strength under bending modes. Existing methods of mitigating the problem include (i) using glass with higher CTE, (ii) plugging the vias in the glass with dielectric material and drilling a hole with laser, or (iii) using conformal plating of metal (e.g. Cu) and then backfill with dielectric material. However, these existing methods lead to compromises in product performance or VIA scaling. For example, glass with higher CTE is not suitable for large die complex assembly and will lead to first level interconnect (FLI) stress, bump cracking, loss or coplanarity during assembly, etc. As another example, plugging with dielectric material followed by drilling would sacrifice diameter and bump pitch (BP) of the TGVs since large holes are needed to account for large laser diameter and laser process tolerance. As yet another example, conformal plating followed by backfill similarly sacrifices diameter and BP of TGVs since large holes are needed for backfilling and maintaining sufficient volume of Cu to manage current density. This approach also limits the metal (e.g. Cu) volume leading to electrical limitations. Hence, the existing methods are not satisfactory.

### Brief Description of the Drawings

Throughout the drawings, it should be noted that like reference numbers are used to depict the same or similar elements, features, and structures. The drawings are not necessarily to scale, emphasis instead generally being placed upon illustrating aspects of the disclosure. In the following description, some aspects of the disclosure are described with reference to the following drawings, in which:
FIG. 1A shows a schematic diagram of an apparatus for coating a glass substrate having a plurality of through-holes according to various aspects;
FIG. 1B shows a schematic plan view of an example of a support frame for the apparatus of FIG. 1A according to various aspects;
FIG. 1C shows a schematic plan view of another example of a support frame for the apparatus of FIG. 1A according to various aspects;
FIG. 2A shows a schematic diagram of an apparatus for coating the glass substrate having the plurality of through-holes according to various aspects;
FIG. 2B shows an illustration of the coating process using the apparatus of FIG. 2A;
FIG. 3 shows a schematic diagram of an apparatus for coating the glass substrate having the plurality of through-holes according to various aspects;
FIG. 4A shows a schematic diagram of an apparatus for coating the glass substrate having the plurality of through-holes according to various aspects;
FIG. 4B shows an illustration of the coating process using the apparatus of FIG. 4A;
FIG. 5A shows a schematic diagram of an apparatus for coating the glass substrate having the plurality of through-holes according to various aspects;
FIG. 5B to FIG. 5F illustrate a sequence of coating the glass substrate having the plurality of through-holes using an apparatus according to various aspects;
FIG. 6A to FIG. 6F illustrate a sequence of coating the glass substrate having the plurality of through-holes 104 using an apparatus according to various aspects; and
FIG. 7A to FIG. 7C show schematic diagrams of apparatus for coating the glass substrate having the plurality of through-holes according to various aspects.

### Description

The following detailed description refers to the accompanying drawings that show, by way of illustration, specific details and aspects in which the disclosure may be practiced. One or more aspects are described in sufficient detail to enable those skilled in the art to practice the disclosure. Other aspects may be utilized and structural, logical, and/or electrical changes may be made without departing from the scope of the disclosure. The various aspects of the disclosure are not necessarily mutually exclusive, as some aspects can be combined with one or more other aspects to form new aspects. Various aspects are described in connection with methods and various aspects are described in connection with devices. However, it may be understood that aspects described in connection with methods may similarly apply to the devices, and vice versa.

The term "exemplary" or "example" may be used herein to mean "serving as an example, instance, or illustration". Any aspect or design described herein as "exemplary" is not necessarily to be construed as preferred or advantageous over other aspects or designs.

The terms "at least one" and "one or more" may be understood to include a numerical quantity greater than or equal to one (e.g., one, two, three, four, [...], etc.). The term "a plurality" may be understood to include a numerical quantity greater than or equal to two (e.g., two, three, four, five, [...], etc.).

The phrase "at least one of' with regard to a group of elements may be used herein to mean at least one element from the group consisting of the elements. For example, the phrase "at least one of' with regard to a group of elements may be used herein to mean a selection of: one of the listed elements, a plurality of one of the listed elements, a plurality of individual listed elements, or a plurality of a multiple of listed elements.

The words "plural" and "multiple" in the description and in the claims expressly refer to a quantity greater than one. Accordingly, any phrases explicitly invoking the aforementioned words (e.g., "a plurality of (objects)", "multiple (objects)") referring to a quantity of objects expressly refers more than one of the said objects. The terms "group (of)", "set (of)", "collection (of)", "series (of)", "sequence (of)", "grouping (of)", etc., and the like in the description and in the claims, if any, refer to a quantity equal to or greater than one, i.e. one or more.

The term "system" detailed herein may be understood as a set of interacting elements, wherein the elements can be, by way of example and not of limitation, one or more mechanical components, one or more electrical components, one or more instructions (e.g., encoded in storage media), and/or one or more processors, and the like.

The phrase "support frame" may be used herein to mean a physical structural (or mechanical) element or an elementary (or basic) mechanical part for supporting an object or article placed or attached thereto including, but not limited to, a framework structure, a panel, a carrier, a plate or a board or a sheet or a film or a membrane etc.

The phrase "dispenser head" may be used herein to mean an outlet for dispensing or discharging a liquid. The dispenser head may include one or more nozzles from which the liquid may be dispensed.

The phrase "coating unit" may be used herein to mean a device that utilizes active mechanical mechanism or actuation to facilitate coating.

Various aspects seek to provide an apparatus for coating of glass substrate having a plurality of through-holes. Various aspects also seek to provide a system for coating of the glass substrate having the plurality of through-holes. In particular, the apparatus and system of the various aspects seek to coat the glass substrate having the plurality of through-holes, using liquid coating. In other words, the apparatus and system of the various aspects employ wet processing, using the liquid coating, to coat the glass substrate having the plurality of through-holes. Further, the apparatus and system of the various aspects may fully coat the plurality of through-holes of the glass substrate. Accordingly, the apparatus and system of the various aspects may enable or ensure that the liquid coating may be infiltrated into the plurality of through-holes of the glass substrate for coating.

The apparatus and system of the various aspects may coat the glass substrate having the plurality of through-holes prior to the metallization process for producing through-glass-vias (TGV) substrate. For example, the coatings may be formed along the walls of the plurality of through-holes of the glass substrate before metal, such as copper, are coated (e.g. by electroplating) along the plurality of through-holes of the glass substrate via metallization. With the coating formed between the glass and the metal, the issue of the coefficients of thermal expansion (CTE) mismatch between glass and metal in the vias of the TGV substrate may be mitigated because the coating can be a material that is low modulus, elastic, compressible, etc such as to mitigate stresses.

In the various aspects, the apparatus and the system use liquid coating for the coating process. Further, the liquid coating may include complex polymeric blends with options for fillers and dense cross-linking. As an example, the liquid coating may include liquid dielectrics coating. Accordingly, high-performance dielectrics may be selected as the liquid coating and deposited by the apparatus and system of the various aspects.

Further, the apparatus and system of the various aspects may be configured for panel-level processing. The use of liquid coating for coating may allow the apparatus and system of the various aspects to be scalable for implementation in panel-level processing.

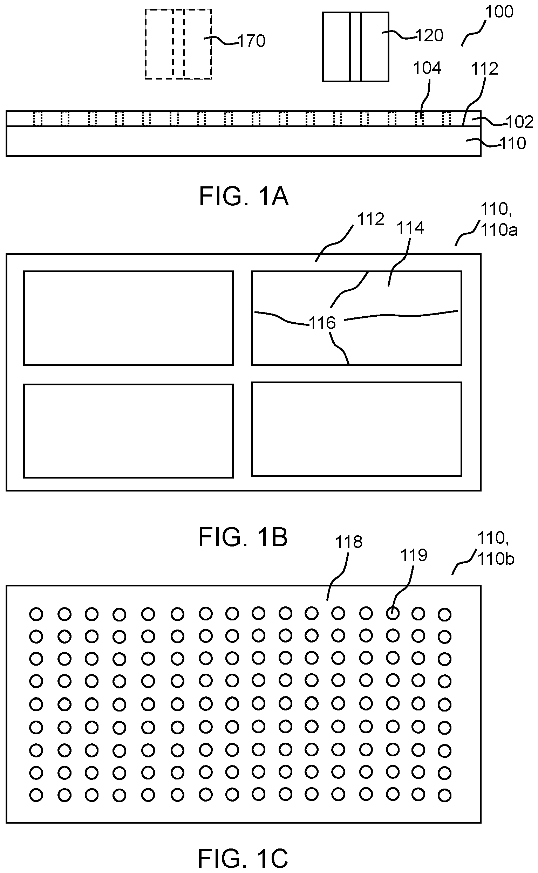

FIG. 1A shows a schematic diagram of an apparatus 100 for coating a glass substrate 102 having a plurality of through-holes 104. The glass substrate 102 with the plurality of through-holes 104 may for producing the through-glass-vias (TGV) substrate, whereby the through-holes 104 may processed to form the vias of the TGV substrate. As shown, the apparatus 100 may include a support frame 110. The support frame 110 may provide support to the glass substrate 102 for holding up the glass substrate 102. Accordingly, the glass substrate 102 may be rested or placed on the support frame 110. Hence, the support frame 110 may bear the weight of the glass substrate 102 and keep the glass substrate 102 in position. Further, the support frame 110 may include one or more abutment portions 112. The one or more abutment portions 112 of the support frame 110 may serve as the support points of the support frame 110 for contacting the glass substrate 102 so as to support the glass substrate 102. Each of the one or more abutment portions 112 of the support frame 110 may be in the form of a point, an edge, or a surface of a corresponding element or structure. According to the various aspects, the one or more abutment portions of the support frame 110 may support the glass substrate 102 in a manner such that the glass substrate 102 may be in a levelled orientation. In the levelled orientation, the glass substrate 102 may be horizontal or parallel to the ground. Accordingly, the one or more abutment portions of the support frame 110 support or cooperatively support the glass substrate 102 in a manner so as to balance the glass substrate 102 in the levelled orientation.

FIG. 1B shows a schematic plan view of an example of the support frame 110 for the apparatus 100 of FIG. 1A. FIG. 1C shows a schematic plan view of another example of the support frame 110 for the apparatus 100 of FIG. 1A. According to various embodiments, the support frame 110 of the apparatus 100 may include at least one opening 114. Accordingly, the support frame 110 may not be a continuous and uninterrupted structure. Rather, the support frame 110 may be of a structure including breaks and/or gaps and/or void and/or unoccupied space.

As shown in FIG. 1B, according to an example of the support frame 110, the support frame 110 may include a plurality of struts 116. The plurality of struts 116 may be joined together to form the support frame 110. Accordingly, the plurality of struts 116 may form a framework structure 110a serving as the support frame 110. Further, the plurality of struts 116 may serve as the one or more abutment portions of the support frame 110 for supporting the glass substrate 102. Accordingly, the plurality of struts 116 may contact or abut the glass substrate 102 when the glass substrate is rested or placed on the support frame 110 such that the plurality of struts 116 may cooperatively bear the weight of the glass substrate 102 and balance the glass substrate 102 in the levelled orientation. In addition, one or more empty spaces may be defined between the plurality of struts 116. Hence, the one or more empty spaces may serve as the at least one opening 114. As an example, the plurality of struts 116 may form a framework structure 110a with a rectangular border and a cross arrangement in the center to divide the framework structure 110a into four quarters wherein an opening 114 is defined in each quarter.

As shown in FIG. 1C, according to another example of the support frame 110, the support frame 110 may include a panel 110b having a main surface 118 with a plurality of perforations 119. The panel 110b may be a broad and thin structure and the main surface 118 may be one of the two broad surfaces of the panel 110b. Each of the plurality of perforations 119 may be a hole passing through the panel 110b. The main surface 118 of the panel 110b may serve as the one or more abutment portions of the support frame 110 for supporting the glass substrate 102 in the levelled orientation. Hence, the glass substrate 102 may be supported on the panel 1 10b. Accordingly, the main surface 118 of the panel 110b may contact or abut the glass substrate 102 when the glass substrate is rested or placed on the panel 110b such that the main surface 118 may bear the weight of the glass substrate 102 and balance the glass substrate 102 in the levelled orientation. Unlike the framework structure 110a of FIG. 1B, the panel 110b may not have the plurality of struts 116 to define the at least one opening 114, but each of the plurality of perforations 119 of the panel 110b may be treated as the at least one opening 114 of the support frame 110 when the support frame 110 is in the form of the panel 110b. As an example, the panel 110b may have a rectangular shape and the plurality of perforations 119 may be holes puncture through the panel 110b. The plurality of perforations 119 may be in a uniform pattern arrangement or be in a non-uniform pattern arrangement.

Referring back to FIG. 1A, the apparatus 100 may include a dispenser head 120. The dispenser head 120 may be movable relative to the support frame 110. Accordingly, when the glass substrate 102 is placed or rested on the support frame 110, the dispenser head 120 may be movable relative to the glass substrate 102. The dispenser head 120 may be movable along a plane parallel to the glass substrate 102 (or the support frame 110). For example, the dispenser head 120 may be mounted to a gantry robot or a cartesian robot or a linear robot for moving along the plane parallel to the glass substrate 102 (or the support frame 110). Further, the dispenser head 120 may be operable to deposit a liquid coating on the glass substrate 102 supported on the support frame 110. Accordingly, the dispenser head 120 may be controlled to dispense the liquid coating for depositing the liquid coating on the glass substrate 102 when the glass substrate 102 is in place on the support frame 110. With the glass substrate 102 being on the support frame 110, a backside of the glass substrate 102 may be in contact with the support frame 110 and the dispenser head 120 may be suspended above a topside of the glass substrate 102 so as to deposit the liquid coating on the topside of the glass substrate 102. The topside of the glass substrate 102 and the backside of the glass substrate 102 may be opposite sides of the glass substrate 102.

According to various aspects, the at least one opening 114 in the support frame 110 (e.g. the one or more empty spaces may be defined between the plurality of struts 116 of the framework structure 110a in FIG. 1B or the plurality of perforations 119 of the panel 110b in FIG. 1C) may be in fluid communication with the plurality of through-holes 104 of the glass substrate 102 when the glass substrate 102 is supported on the support frame 110. Fluid communication between the plurality of through-holes 104 of the glass substrate 102 and the at least one opening 114 in the support frame 110 means that fluid, e.g. liquid, may flow and transfer from the plurality of through-holes 104 of the glass substrate 102 to the at least one opening 114 in the support frame 110. Accordingly, the at least one opening 114 of the support frame 110 may be configured according to the arrangement of the plurality of the through-holes 104 in the glass substrate 102 to be placed on the support frame 110 so as to establish the fluid communication when the glass substrate 102 is placed thereon. When the glass substrate 102 is in position on the support frame 110, the at least one opening 114 in the support frame 110 and the plurality of through-holes 104 of the glass substrate 102 may form fluid paths such that the liquid coating deposited by the dispenser head 120 may flow through the plurality of through-holes 104 of the glass substrate 102 and drained through the at least one opening 114 in the support frame 110 (for example via gravity). Excess liquid coating may be drained through the at least one opening 114 in the support frame 110 so as to keep the plurality of through-holes 104 of the glass substrate 102 "open" as the liquid coating coats the plurality of through-holes 104 of the glass substrate 102. In other words, the liquid coating may not fill up or close the plurality of through-holes 104 of the glass substrate 102 during the coating process. The drained liquid coating may subsequently be collected by a collector (e.g. a drip tray) disposed below the support frame 110. Hence, in this manner, the liquid coating may permeate through the plurality of through-holes 104 of the glass substrate 102 and coat the walls of the plurality of through-holes 104 of the glass substrate 102.

According to some aspects, the support frame 110 may include one or more alignment element such that the glass substrate 102 may be placed in a predetermined alignment with the support frame 110 so as to ensure that the at least one opening 114 of the support frame 110 and the plurality of the through-holes 104 in the glass substrate 102 may form the fluid communication when the glass substrate 102 is supported in the predetermined alignment on the support frame 110. As an example, the one or more alignment element may include, but not limited to, alignment markers or alignment structures (e.g. raised edge, protrusions, etc.).

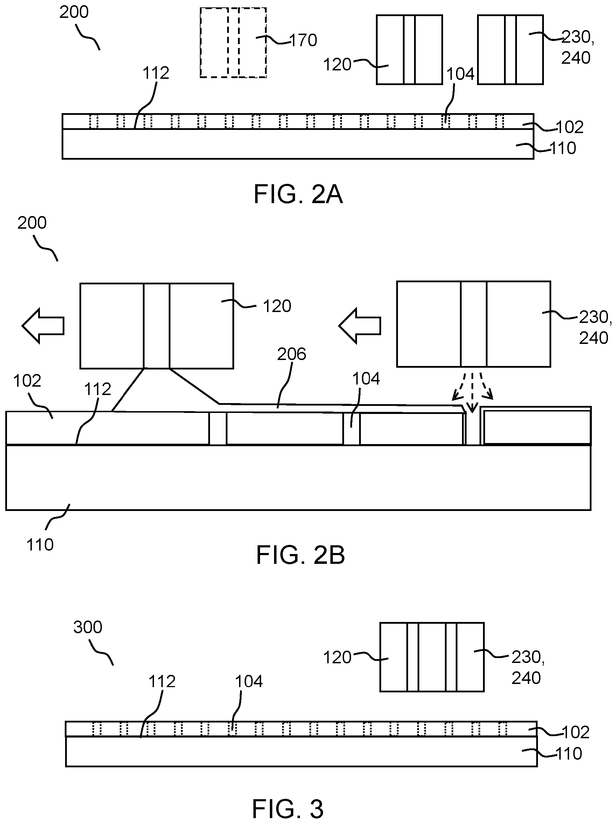

FIG. 2A shows a schematic diagram of an apparatus 200 for coating the glass substrate 102 having the plurality of through-holes 104. FIG. 2B shows an illustration of the coating process using the apparatus 200. The apparatus 200 may be a variant of the apparatus 100 of FIG. 1A. According to various aspects, the apparatus 200 may, similar to the apparatus 100 of FIG. 1A, include the support frame 110 and the dispenser head 120. In the following, elements of the apparatus 200 which are the same as those described earlier with reference to the elements of the apparatus 100 of FIG. 1A are assigned the same reference numerals, and repetition of their corresponding descriptions is omitted for brevity. The descriptions as follows focus on the various possible additional features, limitations and/or details of the apparatus 200.

According to various aspects, the apparatus 200 may include a coating unit 230. The coating unit 230 may be operable to apply a force on the liquid coating so as to urge the liquid coating to permeate the plurality of through-holes 104 in the glass substrate 102. Accordingly, the coating unit 230 may generate the force and transmit the force to the liquid coating. The force may be external to the liquid coating and may cause the liquid coating to flow in a manner directed or guided or influenced by the force. Further, the coating unit 230 may channel the force in a pre-determined direction or path that may cause the liquid coating to infiltrate or seep or pass through the plurality of through-holes 104 of the glass substrate 102. Accordingly, the coating unit 230 may urge the liquid coating to permeate or percolate the plurality of through-holes 104 of the glass substrate 102 for coating the plurality of through-holes 104 of the glass substrate 102.

According to various aspects, the coating unit 230 of the apparatus 200 may include an air blower 240. The air blower 240 may be movable relative to the support frame 110. Accordingly, when the glass substrate 102 is placed or rested on the support frame 110, the air blower 240 may be movable relative to the glass substrate 102. For example, the air blower 240 may be movable along a plane parallel to the glass substrate 102 (or the support frame 110). According to various aspects, the air blower 240 may be configured to blow or vent out ambient air, and/or gases mixtures and/or inert gases such as Nitrogen or Argon.

Referring to FIG. 2B, the dispensing head 120 may deposit a liquid coating 206 on the glass substrate 102 and the air blower 240 may be operable to generate an airflow to spread the liquid coating 206 and push the liquid coating 206 into the plurality of through-holes 104 in the glass substrate 102. The air blower 240 may be an airflow generating device. As an example, the air blower 240 may include a fan, a centrifugal blower, an axial blower, a slit blower, or an air knife. Accordingly, the air blower 240 may set the air in motion to generate the airflow such that the air may impinge or strike the liquid coating 206 so as to apply the force on the liquid coating. With the airflow exerting the force on the liquid coating 206, the airflow may urge the liquid coating 206 to spread on the glass substrate 102 (e.g. along a surface of the glass substrate on which the liquid coating is deposited) as well as urge and push the liquid coating 206 into the plurality of through-holes 104 in the glass substrate 102. Furthermore, the air blower 240 may be suspended above the support frame 110. Accordingly, when the glass substrate 102 is on the support frame 110, the backside of the glass substrate 102 may be in contact with the support frame 110 and the air blower 240 may be suspended above the topside of the glass substrate 102 so as to direct the airflow directly on the liquid coating 206 on the topside of the glass substrate 102 for urging the liquid coating to spread and permeate into the plurality of through-holes 104 of the glass substrate 102.

According to various aspects, the support frame 110 in the apparatus 200 may, similar to the support frame 110 of the apparatus 100 of FIG. 1A, include the at least one opening 114. Accordingly, when the liquid coating 206 is urged and pushed into the plurality of through-holes 104 in the glass substrate 102 by the airflow generated by the air blower 240, excess liquid coating may be pushed and drained through the at least one opening 114 of the support frame 110. With the excess liquid coating pushed and drained through the at least one opening 114 in the support frame 110 by the airflow from the air blower 240, the plurality of through-holes of the glass substrate 102 may be kept "open" as the liquid coating coats the plurality of through-holes 104 of the glass substrate 102. In other words, the liquid coating may not fill up or close the plurality of through-holes 104 of the glass substrate 102 during the coating process. The drained liquid coating may then be collected by a collector (e.g. a drip tray) disposed below the support frame 110. Hence, the liquid coating may permeate through the plurality of through-holes 104 of the glass substrate 102 and coat the walls of the plurality of through-holes 104 of the glass substrate 102. In the various aspects, when the support frame 110 of the apparatus 200 includes the at least one opening 114, the support frame 110 may be in the form of the framework structure 110a with the plurality of struts 116 as described in FIG. 1B or the panel 110b with the plurality of perforations 119 as described in FIG. 1C.

According to various aspects, it is understood that, with the air blower 240, the apparatus 200 may also work when the support frame 110 of the apparatus 200 is without the at least one opening 114. In other words, the support frame 110 of the apparatus 200, may be a continuous and uninterrupted structure. For example, the support frame 110 of the apparatus 200 may be a non-perforated panel or plate. Hence, when the glass substrate 102 having the plurality of through-holes 104 is placed on such support frame 110 of the apparatus 200, the support frame 110 may cover the plurality of through-holes 104 of the glass substrate 102 on the backside of the glass substrate 102 in contact with the support frame 110. During operation of the air blower 240, the airflow from the air blower 240 may urge and push the liquid coating into the plurality of through-holes 104 in the glass substrate 102 from the topside of the glass substrate 102 on which the liquid coating is deposited and excess liquid coating may also be pushed out as overflow to the topside of the glass substrate 102. With the excess liquid coating being pushed out as overflow, the liquid coating may coat the plurality of through-holes 104 of the glass substrate 102 without filling up the plurality of through-holes 104 of the glass substrate 102 during the coating process. Hence, the liquid coating may permeate through the plurality of through-holes 104 of the glass substrate 102 and coat the walls of the plurality of through-holes 104 of the glass substrate 102.

According to various aspects, regardless whether the support frame 110 of the apparatus 200 includes the at least one opening 114, the air blower 240 may be operated to disperse the liquid coating 206 through the plurality of through-holes 104 of the glass substrate 102. In the various aspects, the fluid properties of the liquid coating 206 may dictate a thickness of a coating formed within the plurality of through-holes 104 of the glass substrate 102. The fluid properties may include, but not limited to, material adhesion, viscosity, surface tension, or density. Further, the force and/or pressure applied by the air blower 240 may also affect the thickness of the coating. Accordingly, depending on a desired thickness of the coating, the liquid coating 206 with pre-determined fluid properties may be selected according for coating the glass substrate 102 with the plurality of through-holes 104.

As shown, in the apparatus 200, the air blower 240 and the dispenser head 120 may be separate and independent from each other. Accordingly, the air blower 240 and the dispenser head 120 may be independently movable relative to the support frame 110. As an example, the dispenser head 120 may be mounted to a first gantry robot (or cartesian robot or linear robot) and the air blower 240 may be mounted to a second gantry robot (or cartesian robot or linear robot). In such an example, the dispenser head 120 may be moved by the first gantry robot and the air blower 240 may be separately moved by the second gantry robot. As another example, the dispenser head 120 and the air blower 240 may be disposed to different workstations of the apparatus 200. The dispenser head 120 may be at an upstream workstation and the air blower 240 may be at a downstream workstation. Accordingly, the glass substrate 102 may pass through the upstream workstation for the liquid coating 206 to be deposited thereon by the dispenser head 120 before transporting to the downstream workstation for the air blower 240 to act on the liquid coating 206.

FIG. 3 shows a schematic diagram of an apparatus 300 for coating the glass substrate 102 having the plurality of through-holes 104. The apparatus 300 may be a variant of the apparatus 200 of FIG. 2A and FIG. 2B. According to various aspects, the apparatus 300 may, similar to the apparatus 200 of FIG. 2A and FIG. 2B, include the support frame 110, the dispenser head 120 and the coating unit 230 in the form of the air blower 240. In the following, elements of the apparatus 300 which are the same as those described earlier with reference to the elements of the apparatus 200 of FIG. 2A and FIG. 2B are assigned the same reference numerals, and repetition of their corresponding descriptions is omitted for brevity. The descriptions as follows focus on the various possible additional features, limitations and/or details of the apparatus 300.

According to various aspects, the apparatus 300 of FIG. 3 differs from the apparatus 200 of FIG. 2A and FIG. 2B in that the dispenser head 120 and the air blower 240 may be adjacent to each other and movable together as a single unit. According to various aspects, the dispenser head 120 and the air blower 240 may be coupled together. For example, the dispenser head 120 and the air blower 240 may be separate parts integrally joined together as the single unit mounted to a gantry robot or the dispenser head 120 and the air blower 240 may be integrally formed as the single unit mounted to a gantry robot. Further, the dispenser head 120 may be disposed forward of the air blower 240 along a movement direction. In other words, the dispenser head 120 may be in front of the air blower 240 with respect to the movement direction. Accordingly, the dispenser head 120 may dispense and deposit the liquid coating ahead of the air blower 240, and the air blower 240 may subsequently spread and push the liquid coating as it passes over the liquid coating previously deposited by the dispenser head 120. Hence, when the dispenser head 120 and the air blower 240 are coupled together, the air blower 240 may spread and push the liquid coating as the dispenser head 120 is dispensing and depositing the liquid coating.

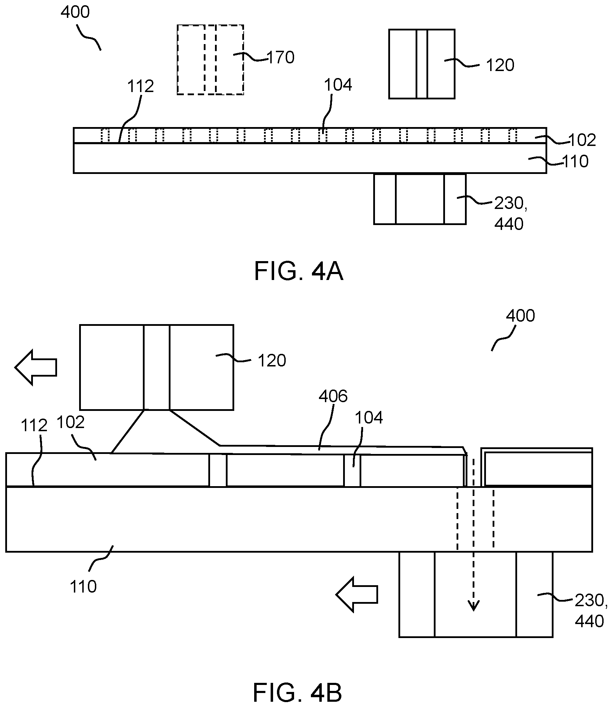

FIG. 4A shows a schematic diagram of an apparatus 400 for coating the glass substrate 102 having the plurality of through-holes 104. FIG. 4B shows an illustration of the coating process using the apparatus 400. The apparatus 400 may be a variant of the apparatus 200 of FIG. 2A and FIG. 2B. According to various aspects, the apparatus 400 may, similar to the apparatus 200 of FIG. 2A and FIG. 2B, include the support frame 110, the dispenser head 120 and the coating unit 230. In the following, elements of the apparatus 400 which are the same as those described earlier with reference to the elements of the apparatus 200 of FIG. 2A and FIG. 2B are assigned the same reference numerals, and repetition of their corresponding descriptions is omitted for brevity. The descriptions as follows focus on the various possible additional features, limitations and/or details of the apparatus 400.

According to various aspects, the apparatus 400 of FIG. 4A and FIG. 4B differs from the apparatus 200 of FIG. 2A and FIG. 2B in that the coating unit 230 of the apparatus 400 may include a suction head 440. The suction head 440 may be disposed at an underneath side of the support frame 110 opposite a topside of the support frame 110 that supports the glass substrate 102. Accordingly, the dispenser head 120 and the suction head 440 may be on opposite sides of the support frame 110. When the glass substrate 102 is placed on the support frame 110, the dispenser head 120 may be above the glass substrate 102 and the suction head 440 may be below the glass substrate 102 (as well as the support frame 110).

According to various aspects, the suction head 440 may be movable relative to the support frame 110. Accordingly, when the glass substrate 102 is placed or rested on the support frame 110, the suction head 440 may be movable relative to the glass substrate 102. For example, the suction head 440 may be movable along a plane parallel to the glass substrate 102 (or the support frame 110).

Referring to FIG. 4B, the dispensing head 120 may deposit a liquid coating 406 on the glass substrate 102 and the suction head 440 may be operable to generate suction (e.g. vacuum) through the at least one opening 114 in the support frame 110 so as to draw the liquid coating 406 to permeate the plurality of through-holes 104 of the glass substrate 102. The suction head 440 may be an inlet part of a suction generation device. For example, the suction generation device may include, but not limited to, a pump, a suction pump, a vacuum pump, or a vacuum generator. Accordingly, the suction head 440 may draw air into the suction head 440 so as to remove air from the at least one opening 114 in the support frame 110 as well as the plurality of through-holes 104 of the glass substrate 102 for creating an air pressure differential so as to generate suction therethrough. With the liquid coating 406 deposited on the glass substrate 102 by the dispenser head 120, the suction head 440 may apply a suction force on the liquid coating 406 through the plurality of through-holes 104 of the glass substrate 102 via the at least one opening 114 in the support frame 110. With the suction force exerting on the liquid coating 206, the suction may draw (or pull) the liquid coating 206 into the plurality of through-holes 104 in the glass substrate 102. Furthermore, the suction head 440 may be directly underneath the support frame 110. According to some aspects, the suction head 440 may also form a seal around the at least one opening in the support frame 110. As an example, the suction head 440 may form the seal along edges of the support frame 110. As another example, the suction head 440 may form the seal along a perimeter of the at least one opening in the support frame 110. When the glass substrate 102 is on the support frame 110, the backside of the glass substrate 102 may be in contact with the support frame 110 and the suction head 440 may directly apply the suction force through the at least one opening 114 in the support frame 110 and the plurality of through-holes 104 of the glass substrate 102 for urging the liquid coating 406 to permeate into the plurality of through-holes 104 of the glass substrate 102.

According to various aspects, the support frame 110 in the apparatus 400 may, similar to the support frame 110 of the apparatus 100 of FIG. 1A, include the at least one opening 114. Since the suction head 440 is disposed underneath the support frame 110, the at least one opening 114 may be needed in the support frame 110 of the apparatus 400 in order for the suction from the suction head 440 to draw (or pull) the liquid coating 406 into the plurality of through-holes 104 of the glass substrate 102. In the various aspects, when the liquid coating 406 is urged and drawn into the plurality of through-holes 104 in the glass substrate 102 by the suction (or a flux of air pressure) generated by the suction head 440, excess liquid coating may be drawn and drained through the at least one opening 114 of the support frame 110. With the excess liquid coating drawn and drained through the at least one opening 114 in the support frame 110 by the suction from the suction head 440, the plurality of through-holes of the glass substrate 102 may be kept "open" as the liquid coating coats the plurality of through-holes 104 of the glass substrate 102. In other words, the liquid coating 406 may not fill up or close the plurality of through-holes 104 of the glass substrate 102 during the coating process as the excess liquid coating may be cleared. The drained liquid coating may then be collected by a collector in the suction generating device. Hence, the liquid coating may permeate through the plurality of through-holes 104 of the glass substrate 102 and coat the walls of the plurality of through-holes 104 of the glass substrate 102. In the various aspects, the support frame 110 of the apparatus 400 may be in the form of the framework structure 110a with the plurality of struts 116 as described in FIG. 1B or the panel 110b with the plurality of perforations 119 as described in FIG. 1C.

According to various aspects, the dispenser head 120 and the suction head 440 may be separate and independent from each other. Accordingly, the dispenser head 120 and the suction head 440 may be independently movable relative to the support frame 110. As an example, the dispenser head 120 may be mounted to a first gantry robot (or cartesian robot or linear robot) and the suction head 440 may be mounted to a second gantry robot (or cartesian robot or linear robot). In such an example, the dispenser head 120 may be moved by the first gantry robot and the suction head 440 may be separately moved by the second gantry robot. As another example, the dispenser head 120 and the suction head 440 may be disposed to different workstations of the apparatus 400. The dispenser head 120 may be at an upstream workstation and the suction head 440 may be at a downstream workstation. Accordingly, the glass substrate 102 may pass through the upstream workstation for the liquid coating 406 to be deposited thereon by the dispenser head 120 before transporting to the downstream workstation for the suction head 440 to act on the liquid coating 406. According to various aspects, the dispenser head 120 and the suction head 440 may be movable together in a synchronous manner. For example, the dispenser head 120 and the suction head 440 may be mounted to a gantry robot such that moving the gantry robot may move the dispenser head 120 and the suction head 440 together in the synchronous manner.

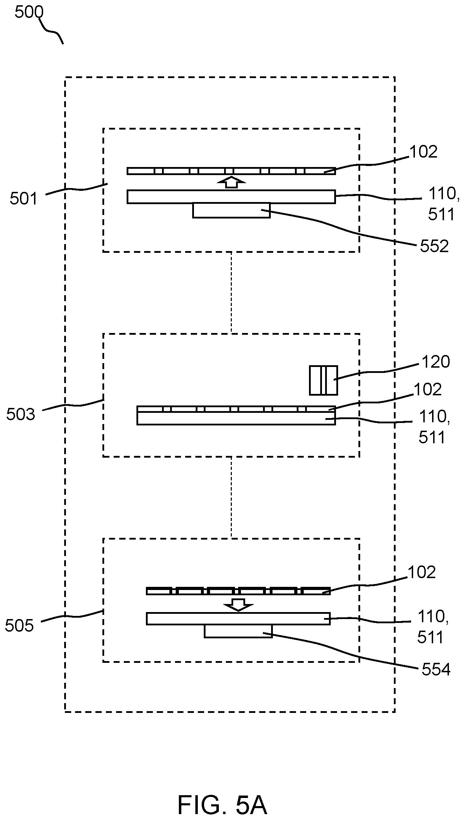

FIG. 5A shows a schematic diagram of an apparatus 500 for coating the glass substrate 102 having the plurality of through-holes 104. The apparatus 500 may be a variant of the apparatus 100 of FIG. 1A. According to various aspects, the apparatus 500 may, similar to the apparatus 100 of FIG. 1A, include the support frame 110 and the dispenser head 120. In the following, elements of the apparatus 500 which are the same as those described earlier with reference to the elements of the apparatus 100 of FIG. 1A are assigned the same reference numerals, and repetition of their corresponding descriptions is omitted for brevity. The descriptions as follows focus on the various possible additional features, limitations and/or details of the apparatus 500.

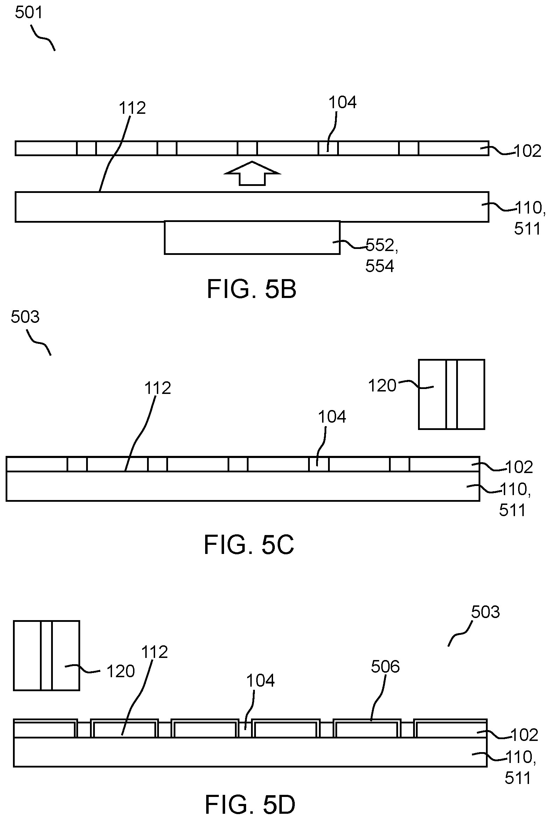

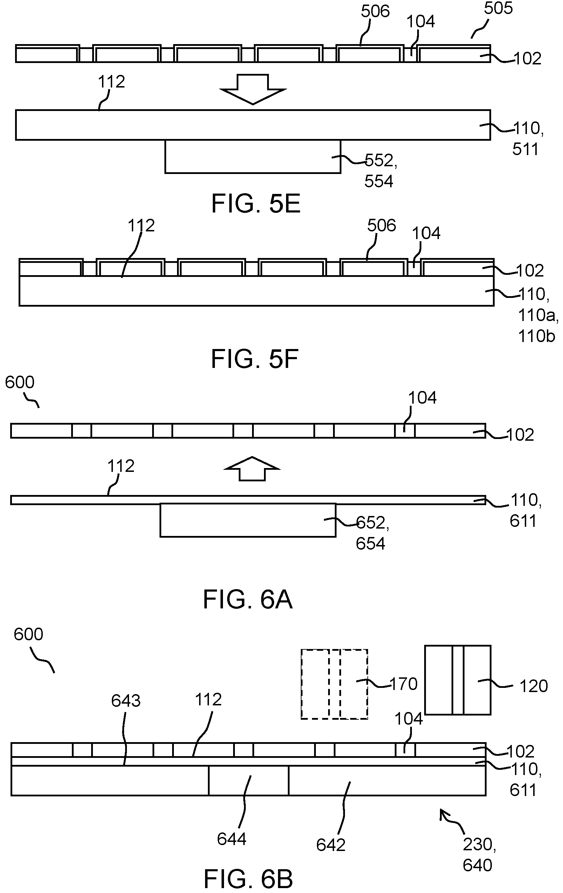

According to various aspects, the apparatus 500 of FIG. 5A may include a plurality of process modules, whereby the glass substrate 102 may be moved or transported or conveyed between the plurality of process modules. Referring to FIG. 5A as an example, the plurality of process modules of the apparatus 500 may include a support mounting module 501, a coating module 503 and/or a support removal module 505. Accordingly, the glass substrate 102 may be moved to the support mounting module 501 for attaching a carrier 511 (see FIG. 5B) to the glass substrate 102. Subsequently, the glass substrate 102 together with the carrier 511 may be moved to the coating module 503 whereby the glass substrate 102 may be coated using the liquid coating (see FIG. 5C and FIG. 5D). The coated glass substrate 102 together with the carrier 511 may then be moved to the support removal module 505 for detaching the carrier 511 from the glass substrate 102 (see FIG. 5E). In an example, the apparatus 500 may include a conveying arrangement including, but not limited to, a robotic arm, a conveyor, a movable stage, a gantry robot, a linear robot, or any suitable conveying mechanism, for moving the glass substrate 102 between the plurality of process modules.

FIG. 5B to FIG. 5F illustrate a sequence of coating the glass substrate 102 having the plurality of through-holes 104 using the plurality of process modules of the apparatus 500 of FIG. 5A.

According to various aspects, the apparatus 500 of FIG. 5A further differs from the apparatus 100 of FIG. 1A in that the support frame 110 may be in the form of the carrier 511 (see FIG. 5B to FIG. 5E). The carrier 511 of the apparatus 500 may be a continuous and uninterrupted structure. For example, the carrier 511 of the apparatus 500 may be a flat panel or plate or board or sheet or film or membrane. In an example implementation, the carrier 511 may include an electrostatic discharge carrier or a backing film. According to various aspects, the carrier 511 of the apparatus 500 may be attached to the glass substrate 102. Accordingly, instead of the glass substrate 102 being merely placed or supported on the support frame 110 of the apparatus 100, 200, 300, 400, the carrier 511 of the apparatus 500 may be adhered to the glass substrate 102 such that the carrier 511 and the glass substrate 102 may be moved or transported together. In the various aspects, when the carrier 511 is attached to the glass substrate 102, the carrier 511 may cover the plurality of through-holes 104 of the glass substrate 102 on a backside of the glass substrate 102 to which the carrier 511 is attached. Accordingly, with the carrier 511 attached to the glass substrate 102, each of the plurality of through-holes 104 of the glass substrate 102 together with the carrier 511 may define a well or a receptacle.

According to various aspects, the apparatus 500 may include a carrier mounting unit 552 (see FIG. 5B) operable to attach the carrier 511 to the glass substrate 102. Further, the apparatus 500 may include a carrier removal unit 554 (see FIG. 5E) operable to detach the carrier 511 from the glass substrate 102. According to some aspects, for example as shown in FIG. 5A, the carrier mounting unit 552 may be in the support mounting module 501 of the apparatus 500, and the carrier removal unit 554 may be in the support removal module 503. According to some aspects, the carrier mounting unit 552 and the carrier removal unit 554 may be integrated in a single support mounting and removal module, whereby the carrier 511 may be attached to the glass substrate 102 and detached from the glass substrate 102 within the single support mounting and removal module. In such a configuration, the glass substrate 102 together with the carrier 511 may be returned to the single support mounting and removal module after the glass substrate 102 is coated. According to some aspects, the carrier mounting unit 552 and the carrier removal unit 554 may be separate and independent from each other. Accordingly, the carrier mounting unit 552 may be operated independently from the carrier removal unit 554, and vice versa.

In an example, when the carrier 511 is an electrostatic discharge carrier, the carrier mounting unit 552 may be a chucking unit. Further, the carrier removal unit 554 may be a de-chucking unit. In another example, when the carrier 511 is a film (e.g. a polyethylene terephthalate (PET) coated film with release adhesive), the carrier mounting unit 552 may be a lamination unit or a hot-roll unit. Further, the carrier removal unit 554 may be a film peeler unit.

In the example as shown in FIG. 5B, in the support mounting module 501, the carrier mounting unit 552 may be operated to attach the carrier 511 to the glass substrate 104. The carrier 511 may then serve as the support frame 110 supporting the glass substrate 104. Further, as shown in FIG. 5C and FIG. 5D, in the coating module 503, the dispensing head 120 may be operated to deposit a liquid coating 506 on the glass substrate 104 on the carrier 511. Subsequently, as shown in FIG. 5E, in the support removal module 505, the carrier removal unit 554 may be operated to detach the carrier 511 from the glass substrate 104.

According to various aspects, the liquid coating 506 used in the apparatus 500 may be of pre-determined fluid properties so as to be capable of permeating the plurality of through-holes 104 of the glass substrate 102 on the carrier 511 upon being deposited on the glass substrate 104. The fluid properties may include, but not limited to, material adhesion, viscosity, surface tension, or density. As an example, the liquid coating 506 may have low viscosity and/or surface tension such that the liquid coating 506 may flow easily and infiltrate the plurality of through-holes 104 of the glass substrate 102 on the carrier 511 without additionally applying an external force to assist the infiltration of the liquid coating 506. According to some aspects, pre-determined dimensions of the plurality of through-holes 104 of the glass substrate 102 may also allow the liquid coating 506 to infiltrate the plurality of through-holes 104 of the glass substrate 102 on the carrier 511 without additionally applying an external force to assist the infiltration of the liquid coating 506. As an example, each of the plurality of through-holes 104 of the glass substrate 102 may be of a sufficiently large dimension such that the liquid coating 506 may flow into and infiltrate the plurality of through-holes 104 of the glass substrate 102 on the carrier 511 on its own.

According to some aspects, as shown in FIG. 5F, after the carrier removal unit 554 removes the carrier 511 from the glass substrate 102, the glass substrate 102 may be moved to a drainage module. In the drainage module, the glass substrate 102 may be placed on the support frame 110 with the at least one opening 114 such that excess liquid coating 506 may be drained from the glass substrate 102. Hence, the apparatus 500 may additionally include the drainage module. As an example, the apparatus 500 may include the support frame 110 in the form of the framework structure 110a with the plurality of struts 116 as described in FIG. 1B or the panel 110b with the plurality of perforations 119 as described in FIG. 1C for draining excess liquid coating 506. In addition, the apparatus 500 may additionally include the air blower 240 as described with reference to apparatus 200 and/or the suction head 440 as described with reference to apparatus 400 to facilitate the draining of the excess liquid coating. Therefore, in some aspects, the apparatus 500 may include the air blower 240 and/or the suction head 440.

FIG. 6A to FIG. 6F illustrate a sequence of coating the glass substrate 102 having the plurality of through-holes 104 using an apparatus 600. The apparatus 600 may be a variant of the apparatus 200 of FIG. 2A and FIG. 2B. According to various aspects, the apparatus 600 may, similar to the apparatus 200 of FIG. 2A and FIG. 2B, include the support frame 110, the dispenser head 120 and the coating unit 230. In the following, elements of the apparatus 600 which are the same as those described earlier with reference to the elements of the apparatus 200 of FIG. 2A and FIG. 2B are assigned the same reference numerals, and repetition of their corresponding descriptions is omitted for brevity. The descriptions as follows focus on the various possible additional features, limitations and/or details of the apparatus 600.

According to various aspects, the apparatus 600 of FIG. 6A to FIG. 6F differs from the apparatus 200 of FIG. 2A and FIG. 2B in that the support frame 110 may be in the form of a carrier 611. The carrier 611 of the apparatus 600 may be similar to the carrier 500 of apparatus 500 of FIG. 5A. Accordingly, repetition of the corresponding descriptions is omitted for brevity. According to various aspects, the apparatus 600 of FIG. 6A to FIG. 6F differs from the apparatus 200 of FIG. 2A and FIG. 2B in that the apparatus 600 may include a carrier mounting unit 652 operable to attach the carrier 611 to the glass substrate 102 and/or a carrier removal unit 654 operable to detach the carrier 611 from the glass substrate 102. The carrier mounting unit 652 and the carrier removal unit 654 of the apparatus 600 may be similar to the carrier mounting unit 552 and the carrier removal unit 554 of the apparatus 500 of FIG. 5A. Accordingly, repetition of the corresponding descriptions is also omitted for brevity. As shown in FIG. 6A, the carrier mounting unit 652 may be operated to attach the carrier 611 to the glass substrate 104. The carrier 611 may then serve as the support frame 110 supporting the glass substrate 104.

According to various aspects, the apparatus 600 of FIG. 6A to FIG. 6F further differs from the apparatus 200 of FIG. 2A and FIG. 2B in that the coating unit 230 of the apparatus 600 may include a spin unit 640. The spin unit 640 may include a spinnable stage 642. The spinnable stage 642 may provide a flat planar surface 643 and may be operable to spin about a spinning axis passing through a center of the flat planar surface 643 of the spinnable stage 642. Further, the spinnable stage 642 may include a vacuum port 644. The vacuum port 644 may be operable to hold down the carrier 611, which is attached to the glass substrate 102, to the spinnable stage 642 via suction so as to retain the glass substrate 102 on the spinnable stage 642. The flat planar surface 643 of the spinnable stage 642 may serve to contact and abut the carrier 611 attached to the glass substrate 102, and the vacuum port 644 may open through the flat planar surface 643 of the spinnable stage 642 for holding down the carrier 611 to the spinnable stage 642. As the carrier 611 is in the form of the continuous and uninterrupted structure, the suction provided by the vacuum port 644 may hold down the carrier 611 to the spinnable stage 642. According to some aspects, the vacuum port 644 may be located at the center of the flat planar surface 643 of the spinnable stage 642. According to some aspects, the spin unit 640 may include one or more vacuum ports 644 in the spinnable stage 642. As shown in FIG. 6B, the carrier 611 together with the glass substrate 104 may be placed on the spinnable stage 642 of the spin unit 640. The vacuum port 644 of the spin unit 640 may be operated to hold down the carrier 611 to the spinnable stage 642.

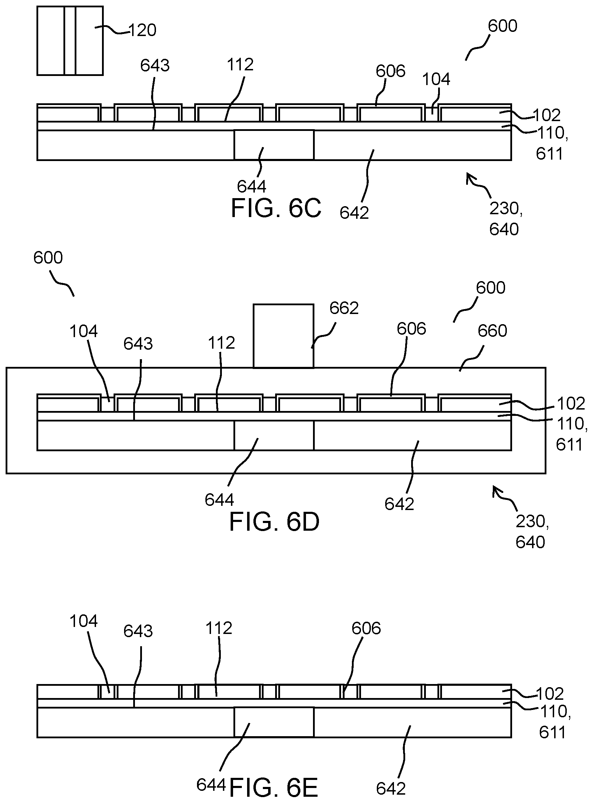

Referring to FIG. 6C, the dispensing head 120 may be operated to deposit a liquid coating 606 on the glass substrate 104 on the carrier 611 held on the spinnable stage 642 of the spin unit 640. With the liquid coating 606 deposited on the glass substrate 104, the spin unit 640 may be operated to spin the spinnable stage 642 so as to spin the carrier 611 together with the glass substrate 102.

The spinning of the glass substrate 102 may cause the liquid coating 606 to permeate the plurality of through-holes 104 in the glass substrate 102 for coating. The rate of spinning of the glass substrate 102 may be controlled by controlling the rate of spinning of the spinnable stage 642 of the spin unit 640. At a first predetermined rate of spinning, the liquid coating may be urged to infiltrate into the plurality of through-holes 104 in the glass substrate 102. When the spinnable stage 642 of the spin unit 640 spins at the first predetermined rate of spinning, the spinnable stage 642 may set the glass substrate 102 in a corresponding spinning motion to result in a first centrifugal force acting on the liquid coating 606. The first centrifugal force exerting on the liquid coating 606 may urge the liquid coating 606 to spread outward radially on the glass substrate 102 (e.g. along a surface of the glass substrate on which the liquid coating is deposited) as well as urge the liquid coating 606 to flow into the plurality of through-holes 104 in the glass substrate 102. The first predetermined rate of spinning may ensure that the liquid coating 606 is uniformly spread to provide an even coating of the glass substrate 102.

Further spinning of the glass substrate 102 may then cause excess liquid coating to propel out of the plurality of through-holes 104 of the glass substrate 102. The spinnable stage 642 of the spin unit 640 may be controlled to spin at a second predetermined rate of spinning for removing the excess liquid coating. When the spinnable stage 642 of the spin unit 640 spins at the second predetermined rate of spinning, the spinnable stage 642 may set the glass substrate 102 in a corresponding spinning motion to result in a second centrifugal force acting on the liquid coating 606. The second centrifugal force exerting on the liquid coating 606 may urge the liquid coating 606 to push the excess liquid coating off the glass substrate 102 (e.g. along a surface of the glass substrate on which the liquid coating is deposited) as well as urge the excess liquid coating to flow out of the plurality of through-holes 104 in the glass substrate 102. The second predetermined rate of spinning may ensure that the excess liquid coating is pushed out while the remaining liquid coating is sufficient to coat the plurality of through-holes 104 of the glass substrate 102.

Referring to FIG. 6D, the apparatus 600 may further include an enclosure 660. The enclosure 660 may be configured for enclosing the spinnable stage 642 of the spin unit 640. According to various aspects, the enclosure 660 may be openable and closeable. When the enclosure 660 is opened, the carrier 611 with the glass substrate 102 attached thereon may be placed on the spinnable stage 642 of the spin unit 640 or the carrier 611 with the glass substrate 102 attached thereon may be removed from the spinnable stage 642. When the enclosure 660 is closed, the carrier 611 with the glass substrate 102 attached thereon and held down on the spinnable stage 642 may be enclosed together inside the enclosure 660. With the glass substrate 102 enclosed inside the enclosure 660, the excess liquid coating being spun off the spinnable stage 642 of the spin unit 640 when spinning at the second predetermined rate of spinning may be caught along the walls of the enclosure 660.

According to various aspects, the apparatus 600 may include a vacuum module 662. The vacuum module 662 may be operatively connected to the enclosure 660. Accordingly, the vacuum module 662 may be operated to remove air from the enclosure 660. As an example, the vacuum module 662 may be operated after the glass substrate 104 is spun by the spin unit 640 for coating. The vacuum generated by the vacuum module 662 may remove any air or bubbles in the plurality of through-holes of the glass substrate 102 or air trapped in the coating. As another example, after the liquid coating 606 is deposited on the glass substrate 102 and before the spin unit 640 is operated to spin the spinnable stage 642 for spinning the glass substrate 102, the vacuum module 662 may be operated to remove air from the enclosure 660 so as to cause the liquid coating 606 to permeate and fill the plurality of through-holes in the glass substrate 102. Hence, the vacuum module 662 may be operated to facilitate pre-filling of the plurality of through-holes of the glass substrate 102 with the liquid coating 606 prior to operating the spin unit 640 to spin the glass substrate 102.

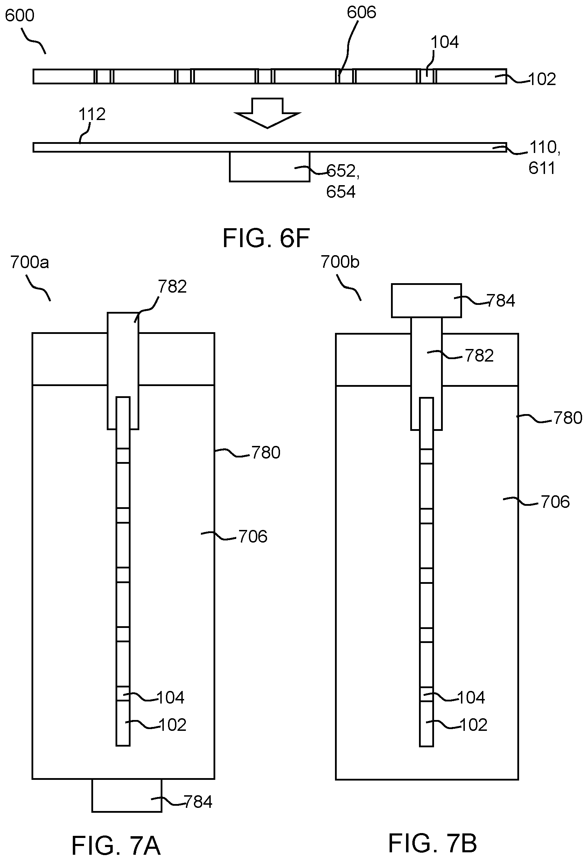

FIG. 6E shows an example the glass substrate 102 with the excess liquid coating on top of the glass substrate 102 cleared and the plurality of through-holes of the glass substrate 102 coated with the liquid coating 606 after the completion of the spinning using the spin unit 640. As shown in FIG. 6F, the carrier removal unit 654 may then be operated to detach the carrier 611 from the glass substrate 104.

Referring to FIG. 1A, FIG. 2A, FIG. 4A and FIG. 6B, each of the apparatus 100, 200, 400 and 600 may further include a solvent dispensing head 170. The solvent dispensing head 170 may be operable to dispense a solvent on the glass substrate 104 prior to the dispenser head 120 depositing the liquid coating on the glass substrate 104. The solvent may pre-wet surfaces on the glass substrate 104 and wall surfaces of the plurality of through-holes 102 of the glass substrate 104. With the respective surfaces pre-wet with the solvent, coating with the liquid coating may be enhanced or better facilitated. According to various aspects, pre-wetting the surfaces with solvent may allow better coating for the through-holes 104 having high aspect ratio. According to various aspects, the application of solvent for pre-wetting may enhance the coating process using the apparatus 100, which is without any coating unit 230, and/or the apparatus 200 having the air blower 240, and/or the apparatus 400 having the suction head 440, and/or the apparatus having the spin unit 640. The solvent may drastically reduce contact angle, assist in overcoming surface tension, and allowing the liquid coating to fill the plurality of through-holes 104 of the glass substrate 102. According to some aspects, the solvent dispensing head 170 may dispense a layer of the solvent with a thickness of 1-10µm before the dispenser head 120 deposit the liquid coating on the glass substrate 104. The thickness and/or amount of the solvent may be adjusted accordingly depending on the type of coating unit 230 as well as the dimensions and aspect ratios of the plurality of through-holes 104 of the substrate 102.

Referring to FIG. 2A, the apparatus 200 with the air blower 240 may include the solvent dispensing head 170. The solvent dispensing head 170 may be movable relative to the support frame 110. For example, the solvent dispensing head 170 may be mounted to a gantry robot or a cartesian robot or a linear robot for moving along a plane parallel to the glass substrate 102 (or the support frame 110). Further, the solvent dispensing head 170 and the dispenser head 120 may be separate and independent from each other. Accordingly, the solvent dispensing head 170 and the dispenser head 120 may be independently movable relative to the support frame 110. Hence, the solvent dispensing head 170 and the dispenser head 120 may be mounted to different gantry robots. Referring to FIG. 4A, similar to the apparatus 200 with the air blower 240, the apparatus 400 with the suction head 440 may also include the solvent dispensing head 170 in a similar manner.

Referring to FIG. 6A to FIG. 6F, the apparatus 600 having the spin unit 640 may include the solvent dispensing head 170. Further, the solvent dispensing head 170 may be operable to dispense the solvent on the glass substrate 102 after the glass substrate 102 is placed on the spinnable stage 642 of the spin unit 640. After the solvent is dispensed on the glass substrate 102, the spin unit 640 may be operated to spin the glass substrate 102 at a desired spinning rate to dictate a thickness of a wetting layer formed by the solvent. Subsequently, the dispensing head 120 may be operated to deposit the liquid coating.

According to various aspects, the solvent may be benign in that the solvent may be miscible with the liquid coating allowing for diffusion. Further, the solvent may be evaporated in later bake procedures allowing the solid dispersion to coat the sidewalls.

According to some aspects, the spin unit 640 of the apparatus 600 may be used for pre-wetting the glass substrate 102 with the solvent. Subsequently, the apparatus 200 with the air blower 240 or the apparatus 400 with the suction head 440 may be used for coating of the glass substrate 102 with the liquid coating.

FIG. 7A to FIG. 7C show schematic diagrams of apparatus 700a, 700b, 700c for coating the glass substrate 102 having the plurality of through-holes 104. According to various aspects, the apparatus 700a, 700b, 700c may include a receptacle 780 containing the liquid coating 706. The receptacle 780 may include, but not limited to, a tank, a container, a vessel, a basin, or a tub. Further, the apparatus 700a, 700b, 700c may include a holder 782. The holder 782 may include, but not limited to, a gripper, a clamp, or a manipulator. The holder 782 may be operable to hold the glass substrate 102. The holder may also be operable to move the glass substrate 102 as well as immerse (or dip) the glass substrate 102 into the liquid coating 706 contained in the receptacle 780. The glass substrate 102 may be fully immersed into the liquid coating 706 such that the liquid coating may ingress into the plurality of through-holes 104. For example, the glass substrate 102 may be immersed in a vertical orientation as shown in FIG. 7A to FIG. 7C. As another example, the glass substrate 102 may be immersed in a horizontal orientation.

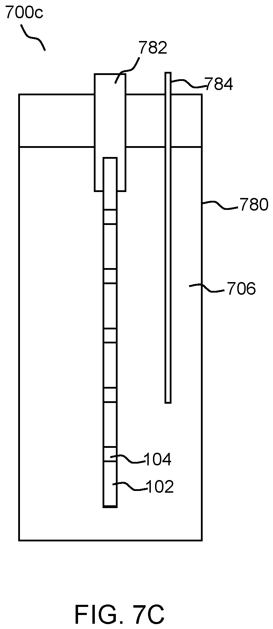

According to various aspects, the apparatus 700a, 700b, 700c may include an agitator 784. The agitator may be operable to agitate the liquid coating 706 and/or the glass substrate 104. By agitating the liquid coating 706 and/or the glass substrate 104, the liquid coating may permeate the plurality of through-holes 102 in the glass substrate 104. For example, as shown in FIG. 7A, the apparatus 700a may include a sonicator serving as the agitator 784. The sonicator may be attached to the receptacle 780 and may be operable to transmit sound waves to agitate the liquid coating 706 so as to cause the liquid coating to permeate the plurality of through-holes 102 in the glass substrate 104. As another example, as shown in FIG. 7B, the apparatus 700b may include a vibrator serving as the agitator 784. The vibrator may be attached to the holder 782 holding the glass substrate 102. Accordingly, the vibrator may vibrate the holder 782 so as to vibrate the glass substrate 102 to cause the liquid coating 706 to permeate the plurality of through-holes 102 in the glass substrate 102. As yet another example, as shown in FIG. 7C, the apparatus 700c may include a stirrer serving as the agitator 784. The stirrer may be operable to stir the liquid coating 706 so as to cause the liquid coating 706 to permeate the plurality of through-holes 104 in the glass substrate 102. According to various aspects, the apparatus 700a, 700b, 700c may uniformly coat low viscosity liquid coating on the glass substrate 102 with the plurality of through-holes 104.

According to various aspects, after the glass substrate 102 is coated with the liquid coating, the glass substrate 102 may be removed from the receptacle 780 of the apparatus 700a, 700b, 700c. If any of the plurality of through-holes 104 of the glass substrate 102 is plugged with the liquid coating, the glass substrate 102 may be provided to the apparatus 200 with the air blower 240 or the apparatus 400 with the suction head 440 to remove excess liquid coating so as to clear the plugged through-hole 104.

According to various aspects, a system for coating a glass substrate having a plurality of through-holes may include the apparatus disclosed herein and the glass substrate provided to the apparatus. In particular, the system may coat the glass substrate, including the plurality of through-holes of the glass substrate, using the liquid coating.

Various aspects have provided an apparatus and/or a system for coating the glass substrate having the plurality of through-holes. The apparatus may use the liquid coating for coating the glass substrate having the plurality of through-holes. In addition, various aspects have provided a passive arrangement and/or an active mechanism to cause the liquid coating to permeate the plurality of through-holes so as to effectively coat the inner walls of the plurality of through-holes. The apparatus and system of the various aspects may be suitable for coating the glass substrate having the plurality of through-holes with liquid dielectric coating prior to the metallization process to produce TGV substrate.

In the following, various examples are described that may refer to one or more aspects of the disclosure.

In Example 1, an apparatus for coating a glass substrate having a plurality of through-holes is disclosed including a support frame including one or more abutment portions configured to support the glass substrate in a levelled orientation; a dispenser head operable to deposit a liquid coating on the glass substrate; and a coating unit configured to apply a force on the liquid coating so as to urge the liquid coating to permeate the plurality of through-holes in the glass substrate.

In Example 2, the apparatus of Example 1 is disclosed, wherein the coating unit includes an air blower movable relative to the support frame, wherein the air blower is operable to generate an airflow to spread the liquid coating and push the liquid coating into the plurality of through-holes in the glass substrate.

In Example 3, the apparatus of Example 2 is disclosed, wherein the air blower is coupled to the dispenser head in a manner so as to be movable together such that the air blower is operable to spread and push the liquid coating as the dispenser head is dispensing the liquid coating.

In Example 4, the apparatus of Example 2 or 3 is disclosed, wherein the support frame includes a plurality of struts joined together, the plurality of struts serving as the one or more abutment portions of the support frame for supporting the glass substrate in the levelled orientation, or wherein the support frame includes a panel having a main surface with a plurality of perforations, the main surface serving as the one or more abutment portions of the support frame for supporting the glass substrate in the levelled orientation.

In Example 5, the apparatus of Example 1 is disclosed, wherein the support frame includes a at least one opening, wherein the coating unit includes a suction head at an underneath side of the support frame opposite a topside of the support frame that supports the glass substrate, the suction head being movable relative to the support frame and operable to generate suction through the at least one opening in the support frame so as to draw the liquid coating to permeate the plurality of through-holes of the glass substrate.

In Example 6, the apparatus of Example 5 is disclosed, wherein the support frame includes a plurality of struts joined together, the plurality of struts serving as the one or more abutment portions of the support frame for supporting the glass substrate in the levelled orientation, wherein one or more spaces defined between the plurality of struts form the at least one opening in the support frame.

In Example 7, the apparatus of Example 5 is disclosed, wherein the support frame includes a panel having a main surface with a plurality of perforations, the main surface serving as the one or more abutment portions of the support frame for supporting the glass substrate in the levelled orientation and the plurality of perforations form the at least one opening in the support frame.

In Example 8, the apparatus of Example 7 is disclosed, wherein the plurality of perforations of the main surface of the support frame is configured to respectively align with the plurality of through-holes of the glass substrate.

In Example 9, the apparatus of Example 1 is disclosed, wherein the support frame includes a carrier configured to be attached to the glass substrate in a manner so as to cover the plurality of through-holes of the glass substrate on a side of the glass substrate to which the carrier is attached.

In Example 10, the apparatus of Example 9 is disclosed, further including a carrier mounting unit configured to attach the carrier to the glass substrate, and a carrier removal unit configured to separate the carrier and the glass substrate.

In Example 11, the apparatus of Example 10 is disclosed, wherein the carrier mounting unit includes a lamination unit or a hot-roll unit when the carrier is a film, or the carrier mounting unit includes a chucking unit when the carrier is an electrostatic discharge carrier.

In Example 12, the apparatus of any one of Examples 9 to 11 is disclosed, wherein the coating unit includes a spin unit including a spinnable stage, the spinnable stage including a vacuum port operable to hold down the carrier to the spinnable stage via suction so as to retain the glass substrate on the spinnable stage, wherein the spin unit is operable to spin the spinnable stage for spinning the carrier together with the glass substrate to cause the liquid coating to permeate the plurality of through-holes in the glass substrate and to cause excess liquid coating to propel out of the plurality of through-holes of the glass substrate due to centrifugal force.

In Example 13, the apparatus of Example 12 is disclosed, wherein the spin unit further includes an enclosure for enclosing the spinnable stage, the enclosure being openable for placing and removing the glass substrate with the carrier from the spinnable stage and closeable for enclosing the glass substrate with the carrier held on the spinnable stage, wherein the spin unit further includes a vacuum module to remove air from the enclosure so as to cause the liquid coating to permeate and fill the plurality of through-holes in the glass substrate.

In Example 14, the apparatus of any one of Examples 1 to 13 is disclosed, further comprising a solvent dispensing head operable to dispense a solvent on the glass substrate prior to the dispenser head depositing the liquid coating.

In Example 15, an apparatus for coating a glass substrate having a plurality of through-holes is disclosed including a support frame including one or more abutment portions configured to support the glass substrate in a levelled orientation, wherein the support frame includes at least one opening; and a dispenser head movable relative to the support frame and operable to deposit a liquid coating on the glass substrate, wherein, the at least one opening in the support frame is configured to be in fluid communication with the plurality of through-holes of the glass substrate when supported thereon so as to provide fluid paths for the liquid coating to permeate through the plurality of through-holes of the glass substrate and drained through the at least one opening in the support frame.

In Example 16, the apparatus of Example 15 is disclosed, wherein the support frame includes a plurality of struts joined together, the plurality of struts serving as the one or more abutment portions of the support frame for supporting the glass substrate in the levelled orientation, wherein one or more spaces defined between the plurality of struts form the at least one opening in the support frame.

In Example 17, the apparatus of Example 15 is disclosed, wherein the support frame includes a panel having a main surface with a plurality of perforations, the main surface serving as the one or more abutment portions of the support frame for supporting the glass substrate in the levelled orientation and the plurality of perforations form the at least one opening in the support frame.

In Example 18, the apparatus of any one of Examples 15 to 17 is discloses, further including a solvent dispensing head operable to dispense a solvent on the glass substrate prior to the dispenser head depositing the liquid coating.

In Example 19, an apparatus for coating a glass substrate having a plurality of through-holes is disclosed including a receptacle containing a liquid coating; a holder configured to hold the glass substrate, the holder being movable to move and immerse the glass substrate into the liquid coating contained in the receptacle; and an agitator operable to agitate the liquid coating or the glass substrate, wherein, the agitator is operable to agitate the liquid coating or the glass substrate to cause the liquid coating to permeate the plurality of through-holes in the glass substrate.

In Example 20, the apparatus of Example 19 is disclosed, wherein the holder comprises a gripper, a clamp, or a manipulator, wherein the agitator comprises a stirrer, a sonicator or a vibrator.

While the disclosure has been particularly shown and described with reference to specific aspects, it should be understood by those skilled in the art that various changes in form and detail may be made therein without departing from the spirit and scope of the disclosure as defined by the appended claims. The scope of the disclosure is thus indicated by the appended claims and all changes, which come within the meaning and range of equivalency of the claims, are therefore intended to be embraced.

## Claims

1. An apparatus for coating a glass substrate having a plurality of through-holes, the apparatus comprising
a support frame comprising one or more abutment portions configured to support the glass substrate in a levelled orientation;
a dispenser head operable to deposit a liquid coating on the glass substrate; and
a coating unit configured to apply a force on the liquid coating so as to urge the liquid coating to permeate the plurality of through-holes in the glass substrate.

2. The apparatus according to claim 1, wherein the coating unit comprises an air blower movable relative to the support frame, wherein the air blower is operable to generate an airflow to spread the liquid coating and push the liquid coating into the plurality of through-holes in the glass substrate.

3. The apparatus according to claim 2, wherein the air blower is coupled to the dispenser head in a manner so as to be movable together such that the air blower is operable to spread and push the liquid coating as the dispenser head is dispensing the liquid coating.

4. The apparatus according to any one of claims 2 or 3,
wherein the support frame comprises a plurality of struts joined together, the plurality of struts serving as the one or more abutment portions of the support frame for supporting the glass substrate in the levelled orientation, or
wherein the support frame comprises a panel having a main surface with a plurality of perforations, the main surface serving as the one or more abutment portions of the support frame for supporting the glass substrate in the levelled orientation.

5. The apparatus according to any one of claims 1 to 4,
wherein the support frame comprises a at least one opening,
wherein the coating unit comprises a suction head at an underneath side of the support frame opposite a topside of the support frame that supports the glass substrate, the suction head being movable relative to the support frame and operable to generate suction through the at least one opening in the support frame so as to draw the liquid coating to permeate the plurality of through-holes of the glass substrate.

6. The apparatus according to claim 5,
wherein the support frame comprises a plurality of struts joined together, the plurality of struts serving as the one or more abutment portions of the support frame for supporting the glass substrate in the levelled orientation,
wherein one or more spaces defined between the plurality of struts form the at least one opening in the support frame.

7. The apparatus according to claim 5,
wherein the support frame comprises a panel having a main surface with a plurality of perforations, the main surface serving as the one or more abutment portions of the support frame for supporting the glass substrate in the levelled orientation and the plurality of perforations form the at least one opening in the support frame.

8. The apparatus according claim 7,
wherein the plurality of perforations of the main surface of the support frame is configured to respectively align with the plurality of through-holes of the glass substrate.

9. The apparatus according to any one of claims 1 to 8,
wherein the support frame comprises a carrier configured to be attached to the glass substrate in a manner so as to cover the plurality of through-holes of the glass substrate on a side of the glass substrate to which the carrier is attached.

10. The apparatus according to claim 9, further comprising
a carrier mounting unit configured to attach the carrier to the glass substrate, and
a carrier removal unit configured to separate the carrier and the glass substrate.

11. The apparatus according to claim 10, wherein the carrier mounting unit comprises a lamination unit or a hot-roll unit when the carrier is a film, or the carrier mounting unit comprises a chucking unit when the carrier is an electrostatic discharge carrier.

12. The apparatus according to any one of claims 9 to 11,
wherein the coating unit comprises a spin unit comprising a spinnable stage, the spinnable stage comprising a vacuum port operable to hold down the carrier to the spinnable stage via suction so as to retain the glass substrate on the spinnable stage,
wherein the spin unit is operable to spin the spinnable stage for spinning the carrier together with the glass substrate to cause the liquid coating to permeate the plurality of through-holes in the glass substrate and to cause excess liquid coating to propel out of the plurality of through-holes of the glass substrate due to centrifugal force.

13. The apparatus according to claim 12,
wherein the spin unit further comprises an enclosure for enclosing the spinnable stage, the enclosure being openable for placing and removing the glass substrate with the carrier from the spinnable stage and closeable for enclosing the glass substrate with the carrier held on the spinnable stage,
wherein the spin unit further comprises a vacuum module to remove air from the enclosure so as to cause the liquid coating to permeate and fill the plurality of through-holes in the glass substrate.

14. The apparatus according to any one of claims 1 to 13, further comprising
a solvent dispensing head operable to dispense a solvent on the glass substrate prior to the dispenser head depositing the liquid coating.
